Europäisches Patentamt

European Patent Office

Office européen des brevets

(11) Veröffentlichungsnummer: **0 427 343 A2**

# (12) EUROPÄISCHE PATENTANMELDUNG

(21) Anmeldenummer: **90202930.5**

(22) Anmeldetag: **06.11.90**

(51) Int. Cl.5: **G01R 33/48**, G01R 33/56

(30) Priorität: **10.11.89 DE 3937428**

(43) Veröffentlichungstag der Anmeldung:
**15.05.91 Patentblatt 91/20**

(84) Benannte Vertragsstaaten:
**DE FR GB NL**

(71) Anmelder: **Philips Patentverwaltung GmbH**
**Wendenstrasse 35 Postfach 10 51 49**
**W-2000 Hamburg 1(DE)**

(84) **DE**

Anmelder: **N.V. Philips' Gloeilampenfabrieken**
**Groenewoudseweg 1**

**NL-5621 BA Eindhoven(NL)**

(84) **FR GB NL**

(72) Erfinder: **Jensen, Jens Dye, Dr.**
**Meyermannweg 10**
**W-2000 Hamburg 54(DE)**
Erfinder: **Vollmann, Wolfgang, Dr.**
**Liaper Strasse 32**
**2000 Berlin 45(DE)**

(74) Vertreter: **Hartmann, Heinrich, Dipl.-Ing. et al**
**Philips Patentverwaltung GmbH**
**Wendenstrasse 35 Postfach 10 51 49**
**W-2000 Hamburg 1(DE)**

(54) **Kernspintomographieverfahren zur Erzeugung getrennter Fett- und Wasserbilder und Anordnung zur Durchführung des Verfahrens.**

(57) Die Erfindung betrifft ein Verfahren zur Erzeugung getrennter Fett- und Wasserbilder von wenigstens einer Schicht, bei dem in Anwesenheit eines stationären Magnetfeldes eine Vielzahl von Sequenzen auf die Schicht einwirkt, wobei jede Sequenz wenigstens einen ersten Hochfrequenzimpuls gefolgt von einem Phasencodierungsgradienten sowie einen Meßgradienten umfaßt, während dessen das in der Schicht erzeugte Kernresonanzsignal erfaßt wird, wobei Gruppen von Sequenzen von mit von Gruppe zu Gruppe abweichender zeitlicher Lage des Meßgradienten und/oder eines etwaigen weiteren Hochfrequenzimpulses gebildet werden und wobei pro Schicht die Anzahl der Sequenzen doppelt so groß ist wie für die Erzeugung eines gleichartigen Bildes ohne Fett-Wasser-Trennung. Zu diesem Zweck ist vorgesehen, daß der Phasencodierungsgradient von Sequenz zu Sequenz in Stufen variiert wird, daß von Stufe zu Stufe der Phasenwinkel jeweils eines Hochfrequenzimpulses der Sequenz um jeweils gleiche Beträge variiert wird und daß aus den erhaltenen Kernresonanzsignalen ein Fett- und ein Wasserbild (F,W) durch eine 2D-Fourier- Transformation erzeugt werden.

Fig. 4a

## KERNSPINTOMOGRAPHIEVERFAHREN ZUR ERZEUGUNG GETRENNTER FETT- UND WASSERBILDER UND ANORDNUNG ZUR DURCHFÜHRUNG DES VERFAHRENS

Die Erfindung betrifft ein Verfahren zur Erzeugung getrennter Fett- und Wasserbilder von wenigstens einer Schicht, bei dem in Anwesenheit eines stationären Magnetfeldes eine Vielzahl von Sequenzen auf die Schicht einwirkt, wobei jede Sequenz wenigstens einen ersten Hochfrequenzimpuls gefolgt von einem Phasencodierungsgradienten sowie einen Magnetgradienten umfaßt, währenddessen das in der Schicht erzeugte Kernresonanzsignal erfaßt wird, wobei Gruppen von Sequenzen von mit von Gruppe zu Gruppe abweichender zeitlicher Lage des Meßgradienten und/oder eines etwaigen weiteren Hochfrequenzimpulses gebildet werden und wobei pro Schicht die Anzahl der Sequenzen doppelt so groß ist wie für die Erzeugung eines gleichartigen Bildes ohne Fett-Wassertrennung.

Ein solches Verfahren ist aus einem Aufsatz von Dixon in der Zeitschrift "Radiology", Vol 153 (1984), Seiten 189-194, bekannt. Eine Ausgestaltung, die pro Sequenz nur einen Hochfrequenzimpuls erfordert, ist in der EP-A 224 310 beschrieben. Den bekannten Verfahren ist gemeinsam, daß jede Sequenz einmal wiederholt wird, wobei lediglich der zeitliche Abstand zwischen den Hochfrequenzimpulsen der Sequenz geändert wird bzw. der zeitliche Abstand zwischen dem einzigen Hochfrequenzimpuls und dem Meßgradienten. Es entstehen somit zwei Gruppen von Sequenzen. Die Zahl der Sequenzen in jeder Gruppe ist so groß wie die Zahl N der Bildpunkte (Pixel) in Richtung des Phasencodierungsgradienten bei den zu erzeugenden (Fett-bzw. Wasser-) Bildern. Die Kernresonanzsignale aus den beiden Gruppen, die sich bei dem jeweils gleichen Phasen codierungsgradienten ergeben, unterscheiden sich lediglich dadurch, daß die eine der beiden voneinander zu trennenden Komponenten, beispielsweise die Fettkomponente bei dem einen Signal die entgegengesetzte Phasenlage hat wie bei dem anderen Kernresonanzsignal. Man kann daher getrennte Fett- bzw. Wasserbilder dadurch erzeugen, daß man entweder zuerst die beiden Gruppen von Sequenzen je einer zweidimensionalen Fouriertransformation unterzieht und die dabei entstehenden Schichtbilder voneinander subtrahiert oder zunächst die Differenz der bei jeweils demselben Phasencodierungsgradienten erhaltenen Kernresonanzsignale bildet, und die so erhaltenen Differenzsignale einer zweidimensionalen Fouriertransformation unterzieht.

Aufgabe der vorliegenden Erfindung ist es, ein Verfahren zur Erzeugung getrennter Fett- und Wasserbilder zu schaffen das auf andere Weise arbeitet. Diese Aufgabe wird ausgehend von dem Verfahren der eingangs genannten Art dadurch gelöst, daß der Phasencodierungsgradient von Sequenz zu Sequenz in Stufen variiert wird, daß von Stufe zu Stufe die Phasenwinkel jeweils eines Hochfrequenzimpulses der Sequenz um jeweils gleiche Beträge variiert werden und daß aus den erhaltenen Kernresonanzsignalen ein Fett- und ein Wasserbild durch eine zweidimensionale Fouriertransformation erzeugt werden.

Bei der Erfindung wird also der Phasencodierungsgradient von Sequenz zu Sequenz in Stufen geändert, so daß keine Sequenz den gleichen Phasencodierungsgradienten hat wie eine andere Sequenz. Während bei den bekannten Verfahren alle Hochfrequenzimpulse den gleichen Phasenwinkel haben können, ändert sich der Phasenwinkel bei der Erfindung von Stufe zu Stufe. Zur Erzeugung von getrennten Fett- bzw. Wasserbildern eine Schicht mit N Pixeln (Bildelementen) in Richtung des Phasencodierungsgradienten und M Pixeln in Richtung des Meßgradienten (wobei z.B. $N = M = 256$ sein kann) müssen nacheinander $2N$ Sequenzen durchgeführt werden, wobei jeweils M Amplitudenwerte des (demodulierten) Kernresonanzsignals digitalisiert werden müssen. Die $2N$ Kernresonanzsignale liefern also einen $2N * M$-Datensatz, der eine Fouriertransformation unterzogen wird. Diese Fouriertransformation erzeugt ein aus $2N * M$ Pixeln bestehendes "Langbild", das sich aus einem Fettbild und einem Wasserbild mit jeweils $N * M$ Pixeln zusammensetzt.

In Weiterbildung der Erfindung ist zur Erzeugung von Fett-bzw. Wasserbildern mehrerer Schichten vorgesehen, daß jeweils ein Hochfrequenzimpuls in jeder Sequenz so gestaltet ist, daß die Schichten durch die Sequenz gleichzeitig angeregt werden, und daß die Phase der Hochfrequenzimpulse von Schicht zu Schicht und von Sequenz zu Sequenz variiert wird.

An sich könnte zur Erzeugung getrennter Fett- und Wasserbilder von mehreren Schichten das erfindungsgemäße Verfahren nacheinander für jede der Schichten durchgeführt werden - gegebenenfalls auch zeitlich verschachtelt (multiple-slice). Bei der erfindungsgemäßen Ausgestaltung des Verfahrens werden die Schichten jedoch gleichzeitig angeregt, so daß sich hinsichtlich des Signal-Rausch-Verhältnisses die Vorteile der Signalmittelung wie bei einem 3D-Verfahren ergeben. Demgemäß werden zur Erzeugung von getrennten Fett- und Wasserbildern für s Schichten $2s * N$ Sequenzen mit von Sequenz zu Sequenz in jeweils gleichen Stufen geändertem Phasencodierungsgradienten erzeugt. Die zweidimensionale Fouriertransformation über die bei der Abtastung der mit den Sequenzen verbundenen Kernresonanzsignale entstehenden Abtastwerte liefert ein einziges "Langbild", das sich aus s Fettbildern und s Wasserbildern zusammensetzt.

Die Erfindung wird nachstehend anhand der Zeichnung näher erläutert. Es zeigen:

Fig. 1 ein Kernspinuntersuchungsgerät, bei dem die Erfindung anwendbar ist,

Fig. 2 ein Blockschaltbild eines solchen Gerätes,

Fig. 3 den zeitlichen Verlauf einer Sequenz, mit der das erfindungsgemäße Verfahren durchführbar ist,

Fig.4a die Lage der Kernmagnetisierungsvektoren in aufeinanderfolgenden Sequenzen bei Anregung einer einzigen Schicht,

Fig.4b das dabei entstehende Langbild,

Fig.5a die Lage der Kernmagnetisierung bei der Anregung zweier Schichten und

Fig.5b das dabei entstehende Langbild.

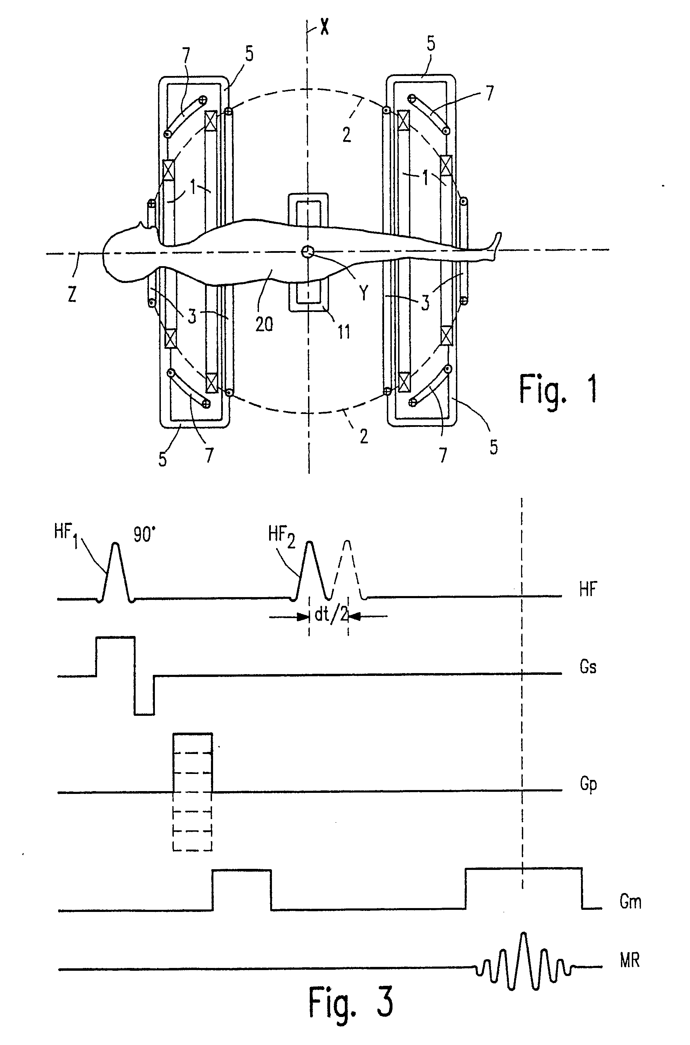

Das in Fig. 1 schematisch dargestellte Kernspin-Untersuchungsgerät enthält eine aus vier Spulen 1 bestehende Anordnung zur Erzeugung eines homogenen stationären Magnetfeldes, das Bruchteile von Tesla, aber auch einige Tesla stark sein kann. Dieses Feld verläuft in z-Richtung eines kartesischen Koordinatensystems. Die zur z-Achse konzentrisch angeordneten Spulen können auf einer Kugeloberfläche 2 angeordnet sein. Im Innern dieser Spulen befindet sich der zu untersuchende Patient 20.

Zur Erzeugung eines in z-Richtung verlaufenden und sich in dieser Richtung linear ändernden Magnetfeldes Gz sind vier Spulen 3 vorzugsweise auf der gleichen Kugeloberfläche an geordnet. Weiterhin sind vier Spulen 7 vorgesehen, die ein ebenfalls in z-Richtung verlaufendes magnetisches Gradientenfeld (d.h. ein Magnetfeld, dessen Stärke sich in einer Richtung linear ändert) Gx erzeugen, dessen Gradient jedoch in x-Richtung verläuft. Ein in z-Richtung verlaufendes magnetisches Gradientenfeld Gy mit einem Gradienten in y-Richtung wird von vier Spulen 5 erzeugt, die die gleiche Form haben können wie die Spulen 7, die jedoch diesen gegenüber um 90° versetzt angeordnet sind. Von diesen vier Spulen sind in Figur 1 nur zwei dargestellt.

Da jede der drei Spulenanordnungen 3, 5 und 7 zur Erzeugung der magnetischen Gradientenfelder Gz, Gy und Gx symmetrisch zur Kugeloberfläche 2 angeordnet ist, ist die Feldstärke im Kugelzentrum, das gleichzeitig den Koordinatenursprung des erwähnten kartesischen xyz-Koordinatensystems bildet, nur durch das stationäre homogene Magnetfeld der Spulenanordnung 1 bestimmt. Weiterhin ist eine Hochfrequenzspule 11 symmetrisch zur Ebene z=0 des Koordinatensystems angeordnet, die so ausgebildet ist, daß damit ein im wesentlichen homogenes und in x-Richtung, d.h. senkrecht zur Richtung des stationären homogenen Magnetfeldes verlaufendes hochfrequentes Magnetfeld erzeugt wird. Der Hochfrequenzspule wird während jedes Hochfrequenzimpulses ein hochfrequenter modulierter Strom von einem Hochfrequenzgenerator zugeführt. Im Anschluß an eine Sequenz dient die Hochfrequenzspule 11 oder eine gesonderte Hochfrequenz-Empfangsspule zum Empfangen der im Untersuchungsbereich erzeugten Kernresonanzsignale.

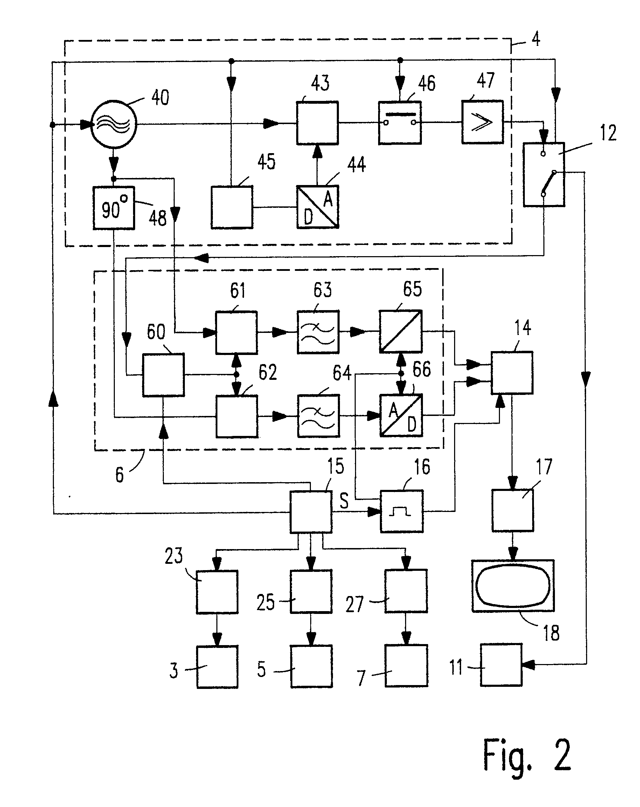

Fig. 2 zeigt ein vereinfachtes Blockschaltbild dieses Kernspin-Untersuchungsgerätes. Die Hochfrequenzspule 11 ist über eine Umschalteinrichtung 12 einerseits an einen Hochfrequenzgenerator 4 und andererseits an einen Hochfrequenzempfänger 6 angeschlossen.

Der Hochfrequenzgenerator 4 enthält einen in Frequenz und Phase durch eine Steuereinheit 15 digital steuerbaren Hochfrequenzoszillator 40, der Schwingungen mit einer Frequenz entsprechend der Larmorfrequenz der anzuregenden Atomkerne bei der von den Spulen 1 erzeugten Feldstärke liefert. Die Larmorfrequenz f berechnet sich bekanntlich nach der Beziehung f = cB, wobei B die magnetische Induktion in dem stationären homogenen Magnetfeld darstellt und c das gyromagnetische Verhältnis, das beispielsweise für Protonen 42,56 MHz/T beträgt. Der Ausgang des Oszillators 40 ist mit einem Eingang einer Mischstufe 43 verbunden. Der Mischstufe wird ein zweites Eingangssignal von einem Digital-Analog-Wandler 44 zugeführt, dessen Ausgang mit einem digitalen Speicher 45 verbunden ist. In dem Speicher sind eine Anzahl von Hüllkurvensignalen - jedes als Folge digitaler Datenworte - gespeichert, von denen bei jeder Sequenz eins ausgelesen wird.

Die Mischstufe 43 verarbeitet die ihr zugeführten Eingangssignale so, daß an ihrem Ausgang die mit dem Hüllkurvensignal modulierte Trägerschwingung erscheint. Das Ausgangssignal der Mischstufe 43 wird über einen von der Steuereinrichtung 15 gesteuerten Schalter 46 einem Hochfrequenz-Leistungsverstärker 47 zugeführt, dessen Ausgang mit der Umschalteinrichtung 12 verbunden ist. Diese wird ebenfalls durch die Steuereinrichtung 15 gesteuert.

Der Empfänger 6 enthält einen Hochfrequenzverstärker 60, der mit der Umschalteinrichtung verbunden ist und dem die in der Hochfrequenzspule 11 induzierten Kernresonanzsignale zugeführt werden, wobei die Umschalteinrichtung den entsprechenden Schaltzustand haben muß. Der Verstärker 60 besitzt einen von der Steuereinrichtung 15 gesteuerten Stummschalteingang, über den er gesperrt werden kann, so daß die Verstärkung praktisch Null ist. Der Ausgang des Verstärkers ist mit den ersten Eingängen zweier multiplikativer Mischstufen 61 und 62 verbunden, die jeweils ein dem Produkt ihrer Eingangssignale entsprechendes Ausgangssignal liefern. Den zweiten Eingängen der Mischstufen 61 und 62 wird ein Signal mit der Frequenz des Oszillators 40 zugeführt, wobei zwischen den Signalen an den beiden Eingängen eine Phasenverschiebung von 90° besteht. Diese Phasenverschiebung wird mit Hilfe eines 90°-Phasendrehgliedes 48 erzeugt, dessen Ausgang mit dem Eingang der Mischstufe 62 und dessen Eingang mit dem Eingang der Mischstufe 61 und mit dem Ausgang des Oszillators 40 verbunden ist.

Die Ausgangssignale der Mischstufe 61 und 62 werden über Tiefpässe 63 und 64, die die vom Oszillator 40 gelieferte Frequenz sowie alle darüberliegenden Frequenzen unterdrücken und niederfrequente Anteile durchlassen, je einem Analog-Digital-Wandler 65 bzw. 66 zugeführt. Dieser setzt die analogen Signale der einen Quadratur-Demodulator bildenden Schaltung 61..64 in digitale Datenworte um, die einem Speicher 14 zugeführt werden. Die Analog-Digital-Wandler 65 und 66 sowie der Speicher 14 erhalten ihre Taktimpulse von einem Taktimpulsgenerator 16, der über eine Steuerleitung von der Steuereinrichtung 15 blockiert bzw. freigegeben werden kann, so daß nur in einem durch die Steuereinrichtung 15 definierten Meßintervall die von der Hochfrequenzspule 11 gelieferten, in den Niederfrequenzbereich transponierten Signale in eine Folge digitaler Datenworte umgesetzt und in dem Speicher 14 gespeichert werden können.

Die im Speicher 14 gespeicherten Datenworte bilden ein Datenfeld, aus dem ein Rechner 17 durch eine zweidimensionale Fouriertransformation ein Langbild errechnet, das sich aus je einem Fett- und einem Wasserbild pro Schicht zusammensetzt, von denen z.B. eines an einen geeigneten Monitor 18 ausgegeben wird.

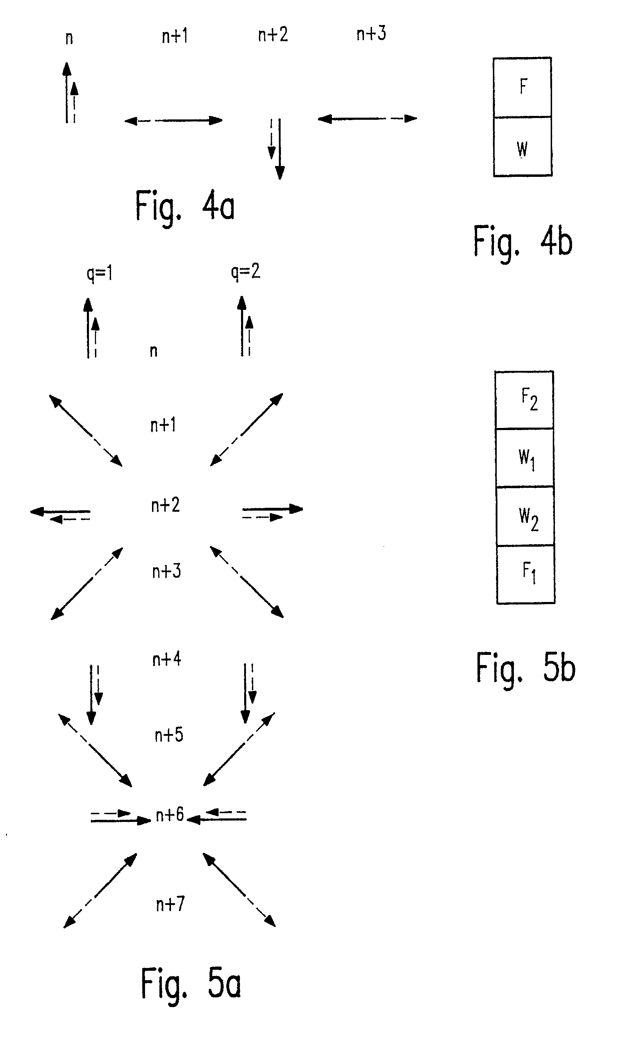

Fig. 3 zeigt den zeitlichen Verlauf einer Sequenz, mit der das erfindungsgemäße Verfahren durchführbar ist. In der ersten Zeile ist die zeitliche Lage der Hochfrequenzimpulse einer Sequenz dargestellt. Der erste Hochfrequenzimpuls $HF_1$ wird von einem Schichtselektionsgradienten $G_s$ (zweite Zeile) begleitet, so daß dadurch eine oder - bei geeignetem zeitlichen Verlauf der Hüllkurve des ersten Hochfrequenzimpulses - mehrere Schichten angeregt werden. Nach dem ersten Hochfrequenzimpuls wird ein Phasencodierungsgradient $G_p$ erzeugt, der von Sequenz zu Sequenz in Stufen variiert wird (dritte Zeile). Die vierte Zeile von Fig. 3 zeigt den zeitlichen Verlauf des Meßgradienten $G_m$. Die drei Gradienten $G_s$, $G_p$ und $G_m$ verlaufen senkrecht zueinander. Sie können mit jeweils einem der drei Gradienten Gx, Gy bzw. Gz identisch sein, müssen es aber nicht. Nach dem ersten Hochfrequenzimpuls und vor dem zweiten Hochfrequenzimpuls wird ein Meßgradient $G_m$ ein-und ausgeschaltet.

Der zweite Hochfrequenzimpuls $HF_2$ ist ein 180°-Impuls, der in Verbindung mit dem ersten Hochfrequenzimpuls $HF_1$ ein Spinechosignal erzeugt. Dieses Spin-Echosignal hat sein Maximum zu einem Zeitpunkt, dessen zeitlicher Abstand vom zweiten Hochfrequenzimpuls genauso groß ist wie der zeitliche Abstand der beiden Hochfrequenzimpulse $HF_1$, $HF_2$ voneinander. Nach dem zweiten Hochfrequenzimpuls wird das magnetische Gradientenfeld wieder eingeschaltet, und zwar derart, daß zu dem Zeitpunkt, an dem das Spin-Echosignal sein Maximum hat, das zeitliche Integral über den Meßgradienten $G_m$ vor dem Hochfrequenzimpuls $HF_2$ gerade genauso groß ist wie das zeitliche Integral über diesem Gradienten nach dem Impuls $HF_2$. Das von einer solchen Sequenz erzeugte Kernresonanzsignal MR - ein Spin-Echosignal - wird abgetastet, während der Meßgradient $G_m$ eingeschaltet wird. In diesem Zeitintervall gibt die Steuereinrichtung 15 den Taktoszillator 16 frei (Fig. 2), so daß das Kernresonanzsignal in Form von M digitalen Abtastwerten in den Speicher 14 übernommen wird.

Zur Durchführung des erfindungsgemäßen Verfahrens wird die in Fig. 3 dargestellte Sequenz unter mehrfacher Modifikation 2N mal wiederholt, wobei N (z.B. 256) die Zahl der Pixel in Richtung des Phasencodierungsgradienten $G_p$ ist, die ein Schichtbild umfassen soll. Für ein Schichtbild mit N = 256 Pixeln müssen pro Schicht 2N Sequenzen durchgeführt werden, für eine einzige Schicht also 512 Sequenzen.

Die Sequenzen werden dabei, wie bereits erwähnt, nicht identisch wiederholt, sondern in dreifacher Hinsicht modifiziert:

a) Bei jeder zweiten Sequenz wird die zeitliche Lage des zweiten Hochfrequenzimpulses um dt/2 verschoben, so daß das von den beiden Hochfrequenzimpulsen $HF_1$ und $HF_2$ erzeugte Spin-Echosignal sein Maximum um die Zeit dt später hat. Für dt gilt dabei die Beziehung:

$$dt = 1/(2df),$$

wobei df die Differenz der Larmorfrequenzen von an Fett bzw. an Wasser gebundenen Protonen ist (df beträgt ca. 3,4 ppm der Larmorfrequenz f). - Diese Modifikation ist auch bei dem Dixon-Verfahren vorgesehen.

b) Der Phasencodierungsgradient wird in 2N gleich großen Stufen (für eine Schicht) variiert. Keine Sequenz hat also einen gleich großen Phasencodierungsgradienten wie eine andere Sequenz - wenn man einmal von mehrfachen Wiederholungen des gesamten Verfahrens zur Verbesserung des Signal-Rausch-Verhältnisses absieht. - Demgegenüber gibt es bei den Dixon-Verfahren stets zwei Sequenzen mit dem gleichen Phasencodierungsgradienten.

c) Mit der stufenweisen Änderung des Phasencodierungsgradienten ändert sich die Phase des ersten Hochfrequenzimpulses $HF_1$ um einen konstanten Betrag von jeweils $90°$. - Demgegenüber ist die Phase der Hochfrequenzimpulse bei dem Verfahren von Dixon bei allen Sequenzen gleich.

Zur Veranschaulichung ist in Fig. 4a die Lage dargestellt, die in der durch $HF_1$ angeregten Schicht die Kernmagnetisierungsvektoren von an Wasser (ausgezogene Linie) und an Fett (gestrichelte Linie) gebundenen Protonen einnehmen - und zwar jeweils zum Empfangszeitpunkt (gestrichelte vertikale Gerade in Fig. 3). Dabei sind vier Sequenzen mit aufeinanderfolgenden Stufen n, $n+1..n+3$ des Phasencodierungsgradienten dargestellt, und es ist angenommen, daß bei der n-ten Stufe die Kernmagnetisierungsvektoren von Fett und Wasser die gleiche Richtung haben, d.h. daß der Hochfrequenzimpuls $HF_2$ die in Fig. 3 mit durchgezogenen Linien dargestellte zeitliche Lage hat.

Bei der Sequenz mit der darauf folgenden Stufe $n+1$ des Phasencodierungsgradienten ist der Kernmagnetisierungsvektor für die an Wasser gebundenen Protonen in der Schicht im Vergleich zur Stufe n um $90°$ gedreht; die Fettkomponente hat die entgegengesetzte Phasenlage wie die Wasserkomponente. Bei der nächsten Stufe $n+2$ ist der Kernmagnetisierungsvektor für Wasser um weitere $90°$ gedreht, und die Kernmagnetisierungsvektoren von Fett und Wasser haben wieder die gleiche Phasenlage. Bei der nächsten Stufe $n+3$ sind die beiden Kernmagnetisierungsvektoren wieder gegenphasig, wobei der Kernmagnetisierungsvektor für Wasser gegenüber der Stufe $n+2$ um weitere $90°$ gedreht ist.

Bei den Sequenzen mit den darauffolgenden Stufen des Phasencodierungsgradienten ($n+4$ usw.) ergibt sich wieder die gleiche Lage der Kernmagnetisierungsvektoren wie bei den Stufen n usw.

Die $90°$-Drehung des Kernmagnetisierungsvektors von Wasser wird dadurch erreicht, daß von Stufe zu Stufe des Phasencodierungsgradienten die Phase des vom Oszillator 40 gelieferten Signals durch die Steuereinheit 15 um jeweils $90°$ umgeschaltet wird, wobei die Frequenz des Oszillatorsignals der Larmorfrequenz von Wasser in der angeregten Schicht entspricht. Die alternierende Gleich- und Gegenphasigkeit der Kernmagnetisierungsvektoren von Wasser und Fett wird dadurch erreicht, daß bei den Sequenzen mit den Stufen n, $n+2$ usw. des Phasencodierungsgradienten der Hochfrequenzimpuls $HF_2$ die in Fig. 3 ausgezogen dargestellte zeitliche Lage hat und bei den Stufen $n+1$, $n+3$ usw. die in Fig. 3 gestrichelt angedeutete zeitliche Lage.

Nachdem auf diese Weise 2N Sequenzen durchgeführt und dabei 2N Kernresonanzsignale jeweils in eine Folge von M digitalen Datenworten umgesetzt worden sind, ergibt sich ein zweidimensionales Datenfeld, das M Abtastwerte mit jeweils dem gleichen Phasencodierungsgradienten enthält und 2N Abtastwerte, die innerhalb des Empfangszeitraums die gleiche zeitliche Lage haben. Führt man daher eine zweidimensionale Fouriertransformation hinsichtlich dieser zeitlichen Lage und hinsichtlich des Phasencodierungsgradienten durch, dann resultiert daraus ein Langbild - in Fig. 4b dargestellt - mit 2N Bildpunkten in Richtung des Phasencodierungsgradienten und M Bildpunkten in Richtung des Meßgradienten. Dieses Langbild umfaßt ein Fettbild und ein Wasserbild der Schicht mit je $N * M$ Bildpunkten.

Bei der in Fig. 3 in Verbindung mit Fig. 4a dargestellten Sequenz werden durch Verändern der zeitlichen Lage von $HF_2$ (in bezug auf $HF_1$) Phasenunterschiede zwischen Fett und Wasser erzeugt. Der gleiche Effekt läßt sich aber auch erreichen, wenn die zeitliche Lage von $HF_2$ stets gleich bleibt und wenn stattdessen bei jeder zweiten Sequenz der in Verbindung mit dem Spin-Echosignal auftretende Meßgradient $G_m$ um den Zeitraum dt verschoben wird. Es ist daher auch möglich, eine Sequenz zu verwenden, die jeweils nur einen einzigen Hochfrequenzimpuls umfaßt, wie in der EP-OS 224 310 im einzelnen beschrieben. Andererseits können auch Sequenzen mit mehr als zwei Hochfrequenzimpulsen benutzt werden, beispielsweise mit drei $90°$-Impulsen, die ein stimuliertes Echosignal erzeugen. In diesem Fall könnte die Phasenlage des ersten Hochfrequenzimpulses konstant bleiben und stattdessen die des dritten Hochfrequenzimpulses variiert werden, der dann schichtselektiv sein muß.

Vorstehend wurde ein Verfahren zur Erzeugung eines Fett-und eines Wasserbildes von einer einzigen Schicht beschrieben. Oft ist es aber erforderlich, solche Bilder von mehreren Schichten zu erhalten. Grundsätzlich könnte zu diesem Zweck das zuvor beschriebene Verfahren nacheinander auf mehrere Schichten angewandt werden, wobei lediglich eine Änderung der Frequenz der Hochfrequenzimpulse erforderlich wäre. Der damit verbundene Zeitaufwand könnte ggf. durch ein Mehrfach-Schichtverfahren (multiple slice) reduziert werden, bei dem vor der erneuten Anregung einer Schicht zunächst die anderen Schichten angeregt werden. Es handelt sich hierbei um sogenannte 2D-Verfahren, die bekanntlich im bezug auf das Signalrauschverhältnis den 3D-Verfahren unterlegen sind.

Im folgenden soll daher die Anwendung der Erfindung bei einem bevorzugten 3D-Verfahren beschrieben werden, dem sogenannten POMP-Verfahren (Glover et al, SMRM 1988, Seite 241). Bei diesem Verfahren werden die zu untersuchenden Schichten - und nur diese - gleichzeitig durch einen Hochfrequenzimpuls angeregt, jedoch mit unterschiedlicher Phase, die sich von Sequenz zu Sequenz ändert. Zur Erzeugung getrennter Fett- und Wasserbilder von s Schichten mit je N Bildpunkten in Richtung des Phasencodierungsgradienten werden dabei 2s * N Sequenzen erzeugt, wobei der Phasenkodierungsgradient in ebenfalls 2s * N gleichmäßig großen Stufen geändert wird. Die Digitalisierung der dabei erhaltenen Kernresonanzsignale liefert ein Datenfeld mit 2s * N * M Abtast- bzw. Amplitudenwerten, die einer 2D-Fourier-Transformation unterzogen werden. Das Ergebnis dieser Transformation ist ein aus s Schichtbildern bestehendes Langbild. Das POMP-Verfahren läßt sich ohne Nachteile auch auf wenige parallele Schichten anwenden und zwar auch dann, wenn diese Schichten nicht unmittelbar aneinander angrenzen. Die Fett-Wasser-Trennung bei diesem POMP-Verfahren kann Sequenzen umfassen, von denen eine in Fig. 3 dargestellt ist. Es können jedoch auch andere Sequenzen verwendet werden. Wesentlich ist nur, daß wenigstens ein schichtselektiver Hochfrequenzimpuls, ein Phasencodierungsgradient und ein Meßgradient vorhanden sind.

Das im folgenden anhand von Fig. 5a und 5b erläuterte Verfahren dient dazu, von z.B. zwei Schichten, die nicht notwendigerweise aneinander angrenzen müssen, je ein Fett- und je ein Wasserbild zu erzeugen. Dazu wird der Phasencodierungsgradient in 4N-Stufen (in einer entsprechenden Anzahl von Sequenzen) geändert. Fig. 5a zeigt die Kernmagnetisierung in den beiden Schichten in acht aufeinanderfolgenden Stufen n....n + 7, wobei die Kernmagnetisierungsvektoren der einen Schicht (q = 1) in der linken Spalte und der anderen Schicht (q = 2) in der rechten Spalte dargestellt sind.

In der Stufe n weisen die Kernmagnetisierungsvektoren von Fett und Wasser zum Empfangszeitpunkt (gestrichelte vertikale Linien in Fig. 3) in beiden Schichten in die gleiche Richtung. In der folgenden Stufe n + 1 ist demgegenüber die Kernmagnetisierung der Wasserkomponente um 45° im Gegenuhrzeigersinn (-45°) und die Fettkomponente um 135° im Uhrzeigersinn (+135°) gedreht, so daß Fett und Wasser in Antiphase sind. Für die zweite Schicht dagegen ist die Wasserkomponente um + 45° gedreht und die Fettkomponente um -135°. Diese Phasendrehung setzt sich in den folgenden Stufen (n + 2 usw.) für jede Schicht und jede der beiden Komponenten unter gleichbleibender Phasendrehung fort, so daß sich nach n + 8 Stufen des Phasencodierungsgradienten wieder die gleiche Lage der Kernmagnetisierungvektoren ergibt.

An sich müßten zur Anregung zweier Schichten - insbesondere, wenn diese einander nicht benachbart sind - zwei Hochfrequenzimpulse mit Oszillatorfrequenzen erzeugt werden, die den sich aus der Einwirkung des Schichtselektionsgradienten $G_s$ - (zweite Zeile von Fig. 3) ergebenden unterschiedlichen Larmorfrequenzen entsprechen. Jeder dieser beiden Hochfrequenzimpulse müßte eine zur Anregung einer Schicht geeignete Umhüllende aufweisen, in der Regel eine sogenannte Sinc-Funktion. Es läßt sich aber zeigen, daß man denselben Effekt mit einem einzigen Hochfrequenzimpuls erreichen kann, dessen Oszillatorfrequenz in der Mitte zwischen den genannten Larmorfrequenzen liegt, wobei die erwähnte Umhüllende mit einer Schwingung moduliert werden muß, deren Frequenz der Hälfte der Differenz der genannten Larmorfrequenzen entspricht. Die Phasenlage dieser Schwingung bestimmt die Phasenlage der Kernmagnetisierungssektoren. Demgemäß müssen für diesen Fall in dem Speicher 45 acht derartige Hüllkurvensignale gespeichert sein, die zyklisch ausgelesen werden, so daß jeweils eines dieser acht Signale die Hüllkurve des Hochfrequenzimpulses $HF_1$ bestimmt und sich die mit diesem Hüllkurvensignal verbundene Phasenlage der Kernmagnetisierung in den beiden Schichten einstellt. Die alternierende Gleich- und Gegenphasigkeit der Fett- und Wasserkomponenten in den beiden Schichten wird - ebenso wie bei dem anhand von Fig. 4a und 4b erläuterten Verfahren - dadurch erzeugt, daß bei den Sequenzen mit den Stufen n + 2, n + 4, n + 6 usw. der zweite Hochfrequenzimpuls $HF_2$ die in Fig. 3 ausgzogen dargestellte zeitliche Lage einnimmt, während er bei den dazwischenliegenden Stufen n + 1......n + 7 usw. die in Fig. 3 gestrichelt dargestellte zeitliche Lage haben muß.

Nachdem auf die geschilderte Weise 4 N-Sequenzen durchgeführt worden sind, ergibt sich ein Datenfeld aus 4 N x M Abtastwerten, das durch eine 2D-Fourier-Transformation in das in Fig. 5b dargestellte Langbild überführt wird, das aus zwei Fettbildern F1, F2 der beiden Schichten und aus zwei Wasserbildern W1, W2 besteht, wobei die beiden Wasserbilder in der Mitte liegen.

Es können auch von mehr als zwei Schichten getrennte Fett-und Wasserbilder hergestellt werden. In diesem Fall sind die Hüllkurvensignale in der Regel noch komplizierter. Dazu müssen 2s * N Sequenzen durchgeführt werden, wobei von Sequenz zu Sequenz der Phasencodierungsgradient $G_p$ in Stufen dG oder ganzzahligen Vielfachen von dG geändert werden muß. Der Phasencodierungsgradient $G_p$ bei den verschiedenen Sequenzen genügt dabei der Beziehung

$$G_p = n * dG + G_{po} \qquad (1)$$

Dabei ist $G_{po}$ ein geeignet gewählter Ausgangswert, beispielsweise Go = - $G_{max}$/2 und n eine von 2s * N aufeinanderfolgenden ganzen Zahlen. Für dG gilt:

$$dG = G_{max}/(2sxN) \quad (2)$$

Dabei ist $G_{max}$ der für die Erzielung des gewünschten Auflösungsvermögens erforderliche Gradient.

Die Phasenlage, die der Hochfrequenzimpuls in den verschiedenen Schichten haben muß, genügt dabei der Beziehung

$$P_1 = n * 180° (q + a)/s \quad (3)$$

Dabei ist $P_1$ die Phasenlage in Grad. q ist eine ganze Zahl zwischen 1 und s und kennzeichnet jeweils eine Schicht. Diese Ziffern können den zu untersuchenden Schichten fortlaufend zugeordnet sein, so daß für die unterste Schicht q = 1 und für die oberste Schicht q = s gilt (oder umgekehrt); es ist jedoch auch möglich, diese Zahlen den Schichten willkürlich zuzuordnen. Eine solche willkürliche Zuordnung entsprechend einer willkürlichen Phasenfolge der Hochfrequenzanregung in aufeinanderfolgenden Schichten erfordert aber sehr komplexe Hüllkurvensignale, weshalb es in der Regel sinnvoller ist, die zu untersuchenden Schichten in auf-oder absteigender Folge zu nummerieren. -

Die Größe a ist eine Konstante, die an sich beliebig gewählt werden kann. Es hat sich jedoch als zweckmäßig erwiesen, für a 0,5 oder ein ungeradzahliges Vielfaches davon zu wählen. Bei einer anderen Wahl von a wird nämlich in dem Langbild eines der Fett- oder Wasserbilder zerteilt, so daß dessen einer Teil am oberen Ende und dessen anderer Teil am unteren Ende des Langbildes zu liegen kommt; außerdem würden für die Realisierung des geforderten zeitlichen Verlaufes des Hochfrequenzimpulses kompliziertere Hüllkurven notwendig.

Man erkennt aus Gleichung 3, daß die Phase $P_1$ der Hochfrequenzmagnetisierung sich von Stufe zu Stufe (d.h. bei Änderung von n um + 1 oder -1) um den Betrag 180° $(q + a)/s$ ändert. Bei dem Ausführungsbeispiel nach Fig. 5a ist s = 2 und a = -3/2, so daß sich dabei eine Änderung von 45° ergibt. Von Schicht zu Schicht (bei gleichbleibendem n) ändert sich $P_1$ um den Betrag 180°/s.

Die mit den verschiedenen Stufen verbundene Verschiebung des zweiten Hochfrequenzimpulses oder des Gradientenfeldes ergibt sich aus der Gleichung für die relative Phasenlage $P_2$ zwischen Fett und Wasser, wobei für $P_2$ gilt:

$$P_2 = n * 180° * b/s \quad (4)$$

Dabei ist b ein ganzzahliger Faktor, der aus dem Wertebereich von 1 bis s gewählt werden kann und der für alle 2sN Sequenzen konstant ist. Wenn $P_2$ = 0°, 360° oder ein Vielfaches von 360° ist, bedeutet dies, daß keine zeitliche Verschiebung vorliegt; $HF_2$ nimmt also die ausgezogen dargestellte zeitliche Lage ein. Wenn hingegen $P_2$ 180° entspricht - oder 540°, 900° usw. -, muß $HF_2$ um dt/2 versetzt werden, wie in Fig. 3 dargestellt bzw. es muß der Meßgradient um dt verschoben werden (bei unveränderter Lage des Hochfrequenzimpulses $HF_2$).

Bei der Erzeugung von Fett- bzw. Wasserbilder von nur einer einzigen Schicht, entsprechend dem in Fig. 4a und 4b dargestellten Ausführungsbeispiel, kann b nur den Wert 1 annehmen, so daß sich mit s = 1 alternierend Phasenlagen von 0° bzw. 180° ergeben, zu denen ggf. noch ein ganzzahliges Vielfaches von 360° addiert ist. Das gleiche gilt bei mehreren Schichten s, wenn b = s gewählt wird; bei dem Ausführungsbeispiel nach Fig. 5a ist also b = 2 gewählt. Wäre stattdessen b = 1 gewählt worden, dann würde sich eine größere Variationsbreite ergeben. Die Phasendifferenz $P_2$ würde dabei zyklisch zwischen 0°,90°, 180° und 270° variieren, so daß in vier aufeinanderfolgenden Sequenzen der zweite Hochfrequenzimpuls $HF_2$ um 0, 1/(8df), um 1/(4df) und um 3/(8df) verschoben werden müßte.

Allgemein gilt für die zeitliche Verschiebung dt von $HF_2$ daher

$$dt = n' * b/s * 1/(4df) \quad (5)$$

wobei $n'$ ein ganzzahliger, möglichst kleiner Wert ist und zwischen n und $n'$ der Zusammenhang besteht:

$$n = n' + y * s \quad (6)$$

wobei y eine geeignet gewählte ganze Zahl ist. Ergibt sich aus Gleichung (5) ein negativer Wert für dt, dann bedeutet dies, daß der Abstand zwischen $HF_1$ und $HF_2$ um dt verringert werden soll. Wenn anstelle von $HF_2$ der Meßgradient $G_p$ zeitlich verschoben werden soll, dann muß der sich aus Gleichung (5) ergebende Wert von dt verdoppelt werden.

Wie bereits erwähnt, liefert ein derartiges Verfahren für s-Schichten 2sN Kernresonanzsignale mit 2sNM Amplituden Werten des Kernsresonanzsignals. Diese digitalisierten Werte bilden ein Datenfeld, daß jeweils M Werte für den gleichen Phasencodierungsgradienten aufweist ($G_p$ = const) und jeweils 2sN Werte mit der gleichen zeitlichen Lage (t = const) innerhalb einer Sequenz. Eine 2-D-Fourier-Transformation F ($G_p$, t) liefert also ein Langbild, das in der einen Richtung M Pixel und in der anderen Richtung 2sN Pixel zählt. Es setzt sich aus 2s Fett- bzw. Wasserbildern zusammen, wobei der Abstand zwischen einem Fett- und einem Wasserbild der gleichen Schicht in dem Beispiel in Fig. 5 gerade s Bilder beträgt. 0b die Fett- oder die Wasserbilder einen zusammenhängenden Block bilden, hängt von der Wahl des Wertes b (Gleichung 4) ab. Wenn b = 1 gewählt ist, folgen Fett- und Wasserbilder alternierend aufeinander, während bei b = s alle Fett- oder Wasserbilder einen zusammenhängenden Block bilden. Der Faktor b gibt also an, wieviel Bilder gleicher Art (Fett oder Wasser) zu einem Block von Bildern innerhalb eines Langbildes gehören.

## Ansprüche

1. Verfahren zur Erzeugung getrennter Fett- und Wasserbilder von wenigstens einer Schicht, bei dem in Anwesenheit eines stationären Magnetfeldes eine Vielzahl von Sequenzen auf die Schicht einwirkt, wobei jede Sequenz wenigstens einen ersten Hochfrequenzimpuls gefolgt von einem Phasencodierungsgradienten sowie einen Meßgradienten umfaßt, während dessen das in der Schicht erzeugte Kernresonanzsignal erfaßt wird, wobei Gruppen von Sequenzen von mit von Gruppe zu Gruppe abweichender zeitlicher Lage des Meßgradienten und/oder eines etwaigen weiteren Hochfrequenzimpulses gebildet werden und wobei pro Schicht die Anzahl der Sequenzen doppelt so groß ist wie für die Erzeugung eines gleichartigen Bildes ohne Fett-WasserTrennung, dadurch gekennzeichnet, daß der Phasencodierungsgradient ($G_p$) von Sequenz zu Sequenz in Stufen variiert wird, daß von Stufe zu Stufe der Phasenwinkel ($P_1$) jeweils eines schichtselektiven Hochfrequenzimpulses ($HF_1$) der Sequenz um jeweils gleiche Beträge variiert wird und daß aus den erhaltenen Kernresonanzsignalen (MR) ein Fett- und ein Wasserbild (F,W) durch eine zweidimensionale Fouriertransformation erzeugt werden.

2. Verfahren nach Anspruch 1 zur Erzeugung eines Fett- und eines Wasserbildes einer einzigen Schicht, dadurch gekennzeichnet, daß die Phasenlage des ersten Hochfrequenzimpulses ($HF_1$) von Stufe zu Stufe um z.B. 90° variiert wird und daß die zeitliche Lage des Meßgradienten ($G_m$) und/oder eines zweiten Hochfrequenzimpulses ($HF_2$) vom ersten Hochfrequenzimpuls von Stufe zu Stufe alternierend vergrößert bzw. verkleinert wird.

3. Verfahren nach Anspruch 1 zur Erzeugung von getrennten Fett- und Wasserbildern mehrerer Schichten, dadurch gekennzeichnet, daß jeweils ein Hochfrequenzimpuls ($HF_1$) in jeder Sequenz so gestaltet ist, daß die Schichten durch die Sequenz gleichzeitig angeregt werden, und daß die Phase ($P_1$) des Hochfrequenzimpulses von Schicht zu Schicht und von Sequenz zu Sequenz variiert wird.

4. Verfahren nach Anspruch 3, dadurch gekennzeichnet, daß der bzw. die Hochfrequenzimpulse so gestaltet sind, daß die Phase $P_1$ der Kernmagnetisierung in der q-ten Schicht und bei der n-ten Stufe des Phasencodierungsgradienten ($G_p$) der Beziehung genügt $P_1 = n * (q + a) * 180°/s$, wobei s die Anzahl der Schichten ist und wobei a vorzugsweise ein ungerades Vielfaches von 1/2 ist.

5. Verfahren nach Anspruch 3 oder 4, dadurch gekennzeichnet, daß von Stufe zu Stufe des Phasencodierungsgradienten ($G_p$) der zeitliche Abstand zwischen dem ersten Hochfrequenzimpuls ($HF_1$) und dem Meßgradienten ($G_m$) und/oder einem weiteren Hochfrequenzimpuls ($HF_2$) der Sequenz vergrößert oder verkleinert wird.

6. Anordnung zur Durchführung des Verfahrens nach Anspruch 1 mit durch Mitteln (1) zur Erzeugung eines homogenen stationären Magnetfeldes, Mitteln (23,25,27) zur Erzeugung von magnetischen Gradientenfeldern, Mitteln (4) zur Erzeugung von Hochfrequenzimpulsen, dadurch gekennzeichnet, daß die Mittel (4) zur Erzeugung von Hochfrequenzimpulsen so gestaltet sind, daß die Phasenlage ($P_1$) wenigstens eines der Hochfrequenzimpulse ($HF_1$) von Sequenz zu Sequenz veränderbar ist.

7. Anordnung nach Anspruch 6, dadurch gekennzeichnet, daß die Mittel zur Erzeugung eines Hochfrequenzimpulses einen Modulator (43) umfassen, in dem ein Signal eines Hochfrequenzoszillators (40) mit dem Signal aus einem Hüllkurvenspeicher (45) moduliert wird, in dem eine Anzahl von Hüllkurvensignalen gespeichert ist, die in zyklischer Folge ausgelesen werden.

Fig. 1

Fig. 3

Fig. 2

n    n+1    n+2    n+3

## Fig. 4a

F

W

## Fig. 4b

q=1    q=2

n

n+1

n+2

n+3

n+4

n+5

n+6

n+7

## Fig. 5a

$F_2$

$W_1$

$W_2$

$F_1$

## Fig. 5b